# EUROPÄISCHE PATENTSCHRIFT

(11) **EP 3 214 764 B1**
(45) Veröffentlichungstag und Bekanntmachung des Hinweises auf die Patenterteilung: **15.04.2020**
(21) Anmeldenummer: 17000197.8
(22) Anmeldetag: 08.02.2017
(51) Int. Cl.: H03K 17/96, H03M 11/24, G01R 31/02

(54) **SENSORSCHALTUNG MIT MEHREREN OPTISCHEN SENSOREN**
SENSOR CIRCUIT WITH A PLURALITY OF OPTICAL SENSORS
CIRCUIT DE CAPTEUR COMPRENANT PLUSIEURS CAPTEURS OPTIQUES

(30) Priorität: 02.03.2016 DE 102016002504
(43) Veröffentlichungstag der Anmeldung: 06.09.2017
(73) Patentinhaber: Diehl AKO Stiftung & Co. KG, 88239 Wangen (DE)
(72) Erfinder: Betiuk, Jakub, 99-400 Lowicz (PL); Kot, Krzysztof, 50-55 Wroclaw (PL); Siesicki, Michal, 52-129 Wroclaw (PL)
(74) Vertreter: Diehl Patentabteilung

(56) Entgegenhaltungen:
- DE-A1- 10 155 847
- GB-A- 2 410 004
- US-A- 5 831 261
- US-A1- 2010 090 746
- US-A1- 2012 062 497

## Beschreibung

Die vorliegende Erfindung betrifft eine Sensorschaltung mit mehreren optischen Sensoren, insbesondere für eine berührungs- und/oder annäherungsempfindliche Bedienvorrichtung.

Berührungs- und/oder annäherungsempfindliche Bedienvorrichtungen ("Touch Control") zum Beispiel für elektronische Haushaltsgeräte weisen in der Regel eine Anzahl entsprechender Bedienelemente auf. Die berührungs- und/oder annäherungsempfindlichen Bedienelemente arbeiten zum Beispiel nach einem optischen, kapazitiven, induktiven oder piezoelektrischen Funktionsprinzip. Im Fall von optischen Bedienelementen ist diesen eine Sensorschaltung mit optischen Sensoren zugeordnet. Bei optischen Sensoren besteht grundsätzlich die Gefahr einer fehlerhaften Signalauswertung durch Umgebungslicht (Sonnenlicht, künstliche Lichtquellen, etc.) und Übersprechen benachbarter Sensoren.

Die GB 2 410 004 A offenbart eine Sensorschaltung mit mehreren optischen Sensoren, auf welcher der Oberbegriff des Anspruchs 1 basiert.

Der Erfindung liegt die Aufgabe zugrunde, eine verbesserte Sensorschaltung mit mehreren optischen Sensoren zu schaffen, die einfach aufgebaut ist und eine Signalauswertung mit geringer Fehlerquote ermöglicht.

Diese Aufgabe wird gelöst durch eine Sensorschaltung mit mehreren optischen Sensoren mit den Merkmalen des Anspruchs 1. Besonders bevorzugte Ausgestaltungen und Weiterbildungen der Erfindung sind Gegenstand der abhängigen Ansprüche.

Bei der erfindungsgemäßen Sensorschaltung mit mehreren optischen Sensoren weisen die mehreren optischen Sensoren jeweils einen optischen Sender und einen optischen Empfänger auf, sind der optische Sender und der optische Empfänger eines optischen Sensors jeweils mit einem spezifischen Steuersignaleingang verbunden, sind die optischen Sender der mehreren optischen Sensoren mit einem gemeinsamen Steuersignaleingang verbunden, sind die optischen Empfänger der mehreren optischen Sensoren mit einem gemeinsamen Messsignalausgang verbunden, und ist eine gemeinsame Signalaufbereitungsschaltung zwischen die optischen Empfänger der mehreren optischen Sensoren und den gemeinsamen Messsignalausgang geschaltet. Gemäß der Erfindung ist den optischen Empfängern der mehreren optischen Sensoren zudem jeweils ein Modulationswiderstand parallel geschaltet, wobei die Modulationswiderstände der mehreren optischen Sensoren zueinander unterschiedliche Widerstandswerte haben.

Durch die Verwendung der gemeinsamen Signalaufbereitungsschaltung können die Messsignale anschließend einfacher bzw. durch eine einfachere Auswertungseinrichtung ausgewertet werden. Da eine gemeinsame Signalaufbereitungsschaltung für die optischen Empfänger der mehreren optischen Sensoren benutzt wird, kann die Sensorschaltung einfacher und mit einer geringeren Anzahl an Bauteilen aufgebaut werden.

Durch die Verwendung spezifischer Steuersignaleingänge für die optischen Sensoren können die optischen Sensoren einzeln und unabhängig voneinander angesteuert werden. So ist es auf einfache Weise möglich, die z.B. nacheinander von den optischen Empfängern der optischen Sensoren erzeugten Messsignale sicher voneinander zu trennen und einzeln auszuwerten. Durch die Auswertung der Messsignale jeweils nur eines optischen Sensors zu einer bestimmten Zeit kann eine Beeinflussung der Auswertung durch ein Übersprechen ("Cross-Talk) zwischen benachbarten optischen Sensoren vermieden werden. Als Folge davon kann vorzugsweise auch auf zusätzliche Maßnahmen wie beispielsweise Sensorrahmen verzichtet werden.

Durch die den optischen Empfängern der mehreren optischen Sensoren parallel geschalteten Modulationswiderstände mit zueinander unterschiedlichen Widerstandswerten können die von den optischen Empfängern erzeugten Messsignale einfach moduliert und im Ergebnis einfach voneinander unterschieden werden.

Die Sensorschaltung der Erfindung kann unter Beibehaltung der erforderlichen Sicherheitsstandards für mehrere Bedienelemente mit einer kleineren Anzahl an aktiven und passiven Bauelementen als herkömmliche Sensorschaltungen aufgebaut werden. Außerdem können durch die erfindungsgemäße Sensorschaltung vorzugsweise Prozessoren mit einer kleineren Anzahl an ADC-Kanälen und/oder einer kleineren Anzahl an GPIO (General Purpose Input/Output) - Kontaktstiften verwendet werden.

Die Sensorschaltung weist wenigstens einen ersten optischen Sensor und einen zweiten optischen Sensor auf. Die Anzahl der optischen Sensoren ist grundsätzlich beliebig und kann insbesondere auch größer als zwei sein. Die optischen Sensoren weisen jeweils einen optischen Sender, vorzugsweise einen IR (Infrarot) - Sender, bevorzugt in Form einer Photodiode, und einen optischen Empfänger, vorzugsweise einen IR-Empfänger, bevorzugt in Form eines Phototransistors, auf.

In einer bevorzugten Ausgestaltung der Erfindung weist die gemeinsame Signalaufbereitungsschaltung eine Spitzenwertdetektorschaltung auf.

Diese Spitzenwertdetektorschaltung weist vorzugsweise zusätzlich eine aktive Reset-Schaltung zum Zurücksetzen des Ausgangssignals der Spitzenwertdetektorschaltung und damit der gemeinsamen Signalaufbereitungsschaltung auf. Die aktive Reset-Schaltung ist bevorzugt als Transistorschaltung ausgestaltet.

In einer bevorzugten Ausgestaltung der Erfindung weist die gemeinsame Signalaufbereitungsschaltung eine Hochpassfilterschaltung auf. Die Grenzfrequenz dieser Hochpassfilterschaltung liegt bevorzugt unterhalb einer PWM-Frequenz eines an den gemeinsamen Steuersignaleingang angelegten PWM-Steuersignals für die optischen Sensoren. Die Hochpassfilterschaltung kann vorzugsweise in einer einfachen Ausführungsform aus einer Kapazität und einem Widerstand aufgebaut sein. Die Verwendung der Hochpassfilterschaltung kann einen Einfluss von Umgebungslicht auf die von den optischen Empfängern der optischen Sensoren erzeugten Messsignale vermindern.

In einer bevorzugten Ausgestaltung der Erfindung ist den optischen Empfängern der mehreren optischen Sensoren jeweils eine Tiefpassfilterschaltung zugeordnet. Falls zum Beispiel Kontaktstifte eines Mikroprozessors zum Ansteuern der optischen Sensoren über die Steuersignaleingänge verwendet werden, so können die relativ hohen Innenwiderstände an diesen Kontaktstiften einen Spannungsabfall mit der PWM-Frequenz des gemeinsamen Steuersignaleingangs erzeugen. Durch die Tiefpassfilterschaltungen kann ein Einfluss solcher Spannungsabfälle auf die von den optischen Sensoren erzeugten Messsignale reduziert werden.

In einer weiteren bevorzugten Ausgestaltung der Erfindung ist eine Aktivierung der optischen Sender der mehreren optischen Sensoren über die spezifischen Steuersignaleingänge und den gemeinsamen Steuersignaleingang separat voneinander modulierbar.

In einer bevorzugten Ausgestaltung der Erfindung sind die spezifischen Steuersignaleingänge der mehreren optischen Sensoren jeweils mit einem ADC-Kanal eines Mikrocontrollers verbunden. In einer alternativen Ausführungsform der Erfindung sind die spezifischen Steuersignaleingänge der mehreren optischen Sensoren jeweils mit einem Ausgang eines Multiplexers oder eines Schieberegisters verbunden.

In weiteren einer bevorzugten Ausgestaltung der Erfindung sind die optischen Sender der mehreren optischen Sensoren mit einem gemeinsamen Fehlersignalausgang verbunden.

Gegenstand der Erfindung ist auch eine Bedienvorrichtung mit mehreren berührungs- und/oder annäherungsempfindlichen Bedienelementen, die eine oben beschriebene Sensorschaltung der Erfindung aufweist. Diese Bedienvorrichtung ist insbesondere in elektronischen Haushaltsgeräten wie beispielsweise Kochfeldern, Herden, Mikrowellenöfen, Spülmaschinen, Wäschebehandlungsgeräten, Kühl- und/oder Gefriergeräten und dergleichen vorteilhaft einsetzbar.

Gegenstand der Erfindung ist zudem ein Verfahren zum Betreiben einer oben beschriebenen Sensorschaltung mit mehreren optischen Sensoren der Erfindung, bei welchem die optischen Sender der mehreren optischen Sensoren über die spezifischen Steuersignaleingänge und den gemeinsamen Steuersignaleingang nacheinander aktiviert werden, die von den Empfängern der mehreren optischen Sensoren erzeugten Messsignale mittels den Empfängern jeweils parallel geschalteten Modulationswiderständen, die zueinander unterschiedliche Widerstandswerte haben, moduliert werden, und die von den Empfängern der mehreren optischen Sensoren erzeugten Messsignale von der gemeinsamen Signalaufbereitungsschaltung aufbereitet und dann ausgewertet werden.

In einer bevorzugten Ausgestaltung der Erfindung wird vor jeder Aktivierungsschleife der optischen Sender der mehreren optischen Sensoren eine Test-Routine der optischen Sensoren ausgeführt.

Obige sowie weitere Merkmale und Vorteile der Erfindung werden aus der nachfolgenden Beschreibung eines bevorzugten, nicht-einschränkenden Ausführungsbeispiels anhand der beiliegenden Zeichnungen besser verständlich. Darin zeigen, zum Teil schematisch:
- Fig. 1: ein Blockschaltbild einer Sensorschaltung gemäß einem Ausführungsbeispiel der vorliegenden Erfindung;
- Fig. 2: ein Ablaufdiagramm einer beispielhaften Test-Routine für die Hochpassfilterschaltung der Sensorschaltung von Fig. 1;
- Fig. 3: ein Ablaufdiagramm einer beispielhaften weiteren Test-Routine für die Hochpassfilterschaltung der Sensorschaltung von Fig. 1;
- Fig. 4: ein Ablaufdiagramm eines ersten Teils einer beispielhaften Signalerfassungsroutine für die Sensorschaltung von Fig. 1; und
- Fig. 5: ein Ablaufdiagramm eines zweiten Teils einer beispielhaften Signalerfassungsroutine für die Sensorschaltung von Fig. 1.

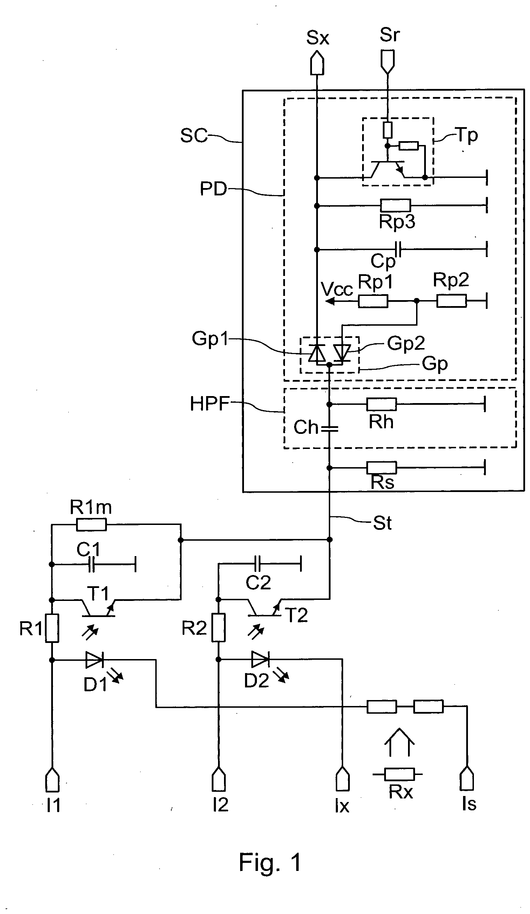

Fig. 1 zeigt eine Sensorschaltung mit zwei optischen Sensoren für eine Bedienvorrichtung mit zwei berührungs- und/oder annäherungsempfindlichen Bedienelementen. Die in Fig. 1 gezeigte Schaltungsanordnung kann vom Fachmann jedoch problemlos auf eine größere Anzahl optischer Sensoren erweitert werden.

Der erste optische Sensor weist eine IR-Photodiode als ersten optischen Sender D1 und einen IR-Phototransistor als ersten optischen Empfänger T1 auf, und der zweite optische Sensor weist eine IR-Photodiode als zweiten optischen Sender D2 und einen IR-Phototransistor als zweiten optischen Empfänger T2 auf. Die optischen Sender D1, D2 sind jeweils einerseits mit einem spezifischen Steuersignaleingang I1, I2 und andererseits mit einem gemeinsamen Steuersignaleingang Is verbunden. Über die Steuersignaleingänge I1, I2, die beispielsweise mit GPIO-Kontakten eines Mikrocontrollers (nicht dargestellt) oder einem Schieberegister verbunden sind, werden die optischen Sender D1, D2 vorzugsweise nacheinander getaktet aktiviert. Über den gemeinsamen Steuersignaleingang Is wird den optischen Sendern D1, D2 beispielsweise ein PWM-Steuersignal ("Pulsweitenmodulation") zugeführt.

Das PWM-Steuersignal ist allen optischen Sensoren gemeinsam. Ein aktivierter spezifischer Steuersignaleingang In aktiviert den entsprechenden optischen Sensor mit seiner optischen Diode Dn und seinem optischen Empfänger Tn, ein deaktivierter spezifischer Steuersignaleingang In (hoher Impedanzzustand) deaktiviert den entsprechenden optischen Sensor. Falls ein Schieberegister für die spezifischen Steuersignaleingänge In verwendet wird, kann der hohe Impedanzzustand ggf. schwierig zu erreichen sein, weshalb in diesem Fall zwischen die spezifischen Steuersignaleingänge In und die optischen Sender Dn vorzugsweise jeweils eine kleine Schottky-Diode geschaltet werden kann.

Außerdem sind die optischen Sender D1, D2 mit einem gemeinsamen Fehlersignalausgang Ix verbunden, der beispielsweise mit einem ADC-Kanal eines Mikrocontrollers (nicht dargestellt) verbunden ist. Zusätzlich ist ein gemeinsamer Shunt-Widerstand Rx vorgesehen. Falls das Fehlersignal am Fehlersignalausgang Ix bei aktiviertem optischem Sender D1, D2 von einem vorbestimmten Wert abweicht, kann daraus auf eine Fehlfunktion des jeweiligen optischen Senders D1, D2 geschlossen werden.

Jedem optischen Sensor ist zudem eine Tiefpassfilterschaltung bestehend aus einer Kapazität Cn und einem Widerstand Rn zugeordnet. Falls zum Beispiel für die spezifischen Steuersignaleingänge In ein Mikrocontroller verwendet wird, so sind die Innenwiderstände seiner Anschlüsse üblicherweise relativ hoch, was zu einem Spannungsabfall mit der Frequenz des PWM-Steuersignals führen kann. Um einen Einfluss dieses Verhaltens zu vermindern, können bevorzugt diese Tiefpassfilterschaltungen eingesetzt werden.

Ferner ist vorzugsweise jedem optischen Sensor ein Modulationswiderstand Rnm zugeordnet (in Fig. 1 ist nur ein solcher Modulationswiderstand R1m für den ersten optischen Sensor gezeigt). Diese Modulationswiderstände Rnm sind insbesondere bei der Verwendung eines Multiplexers oder Schieberegisters an den spezifischen Steuersignaleingängen In von Vorteil, um den geforderten Sicherheitsstandard einzuhalten. Die Modulationswiderstände Rnm der optischen Sensoren haben zueinander leicht unterschiedliche Widerstandswerte, sodass die von den optischen Empfängern Tn der optischen Sensoren erzeugten Messsignale ebenfalls leicht unterschiedliche Messwerte haben ("Modulation").

Die optischen Empfänger Tn der mehreren optischen Sensoren sind mit einer gemeinsamen Messsignalleitung St verbunden. Diese gemeinsame Messsignalleitung St ist mit einem gemeinsamen Messsignalausgang Sx verbunden, der zum Beispiel mit einem ADC-Kanal eines Mikrocontrollers verbunden werden kann.

Wie in Fig. 1 veranschaulicht, ist zwischen die mehreren optischen Sensoren und diesen gemeinsamen Messsignalausgang Sx eine gemeinsame Signalaufbereitungsschaltung SC geschaltet. Aufbau und Funktionsweise dieser gemeinsamen Signalaufbereitungsschaltung SC werden nun näher erläutert.

Die gemeinsame Signalaufbereitungsschaltung SC weist einen Widerstand Rs auf. Dieser Widerstand Rs ist vorgesehen, um das in Form eines Stroms vorliegende Messsignal eines optischen Empfängers Tn in eine zu diesem Strom proportionale Spannung umzuwandeln. Der Widerstandswert dieses Widerstands Rs ist an die t der jeweiligen optischen Empfänger Tn, insbesondere an deren Empfindlichkeit und deren Dunkelstrom anzupassen. Die mit Hilfe dieses Widerstands Rs erzeugte Spannung sollte einerseits so niedrig wie möglich sein, aber andererseits für die weitere Signalaufbereitung einen Spannungswert von etwa 0,6 bis 0,8 V nicht unterschreiten.

Der Widerstand Rs kann auch - zum Beispiel in Reihe mit den Modulationswiderständen Rnm - für eine Test-Routine zum Prüfen der Funktionsfähigkeit der optischen Sensoren genutzt werden.

Das Signal dieses Widerstands Rs wird dann einer Hochpassfilterschaltung HPF der gemeinsamen Signalaufbereitungsschaltung PD zugeleitet. Die Hochpassfilterschaltung HPF ist in einer einfachen Ausführungsform zum Beispiel aus einer Kapazität Ch und einem Widerstand Rh als ein Filter erster Ordnung aufgebaut. Die Grenzfrequenz dieser Hochpassfilterschaltung HPF liegt beispielsweise weit entfernt von 120 Hz (das Doppelte der Frequenz der US-Netzspannung), sollte aber andererseits unterhalb der PWM-Frequenz des PWM-Steuersignals am gemeinsamen Steuersignaleingang Is liegen.

Die gemeinsame Signalaufbereitungsschaltung SC der Sensorschaltung von Fig. 1 weist zudem eine Spitzenwertdetektorschaltung PD auf, der der Hochpassfilterschaltung HPF nachgeschaltet ist. Diese Spitzenwertdetektorschaltung PD weist insbesondere einen Spitzenwertdetektor auf, der in einer einfachen Ausführungsform aus einer ersten Diode Gp1 einer Diodenschaltung Gp, einer Kapazität Cp und einem Widerstand Rp3 aufgebaut ist. In komplexeren Ausführungsformen kann dieser Spitzenwertdetektor zudem einen Komparator aufweisen. Die Kapazität Cp und der Widerstand Rp3 sind an den jeweiligen Anwendungsfall, insbesondere an die jeweiligen optischen Sensoren anzupassen. Die Kapazität Cp und der Widerstand Rp3 sind für die Reaktionszeit des Spitzenwertdetektors maßgebend.

Die Spitzenwertdetektorschaltung PD enthält zudem eine Spannungsteilerschaltung, die einen ersten Widerstand Rp1 und einen zweiten Widerstand Rp2 aufweist. Der Mittelabgriff zwischen den beiden Widerständen Rp1, Rp2 ist über eine zweite Diode Gp2 der Diodenschaltung Gp, die zu der ersten Diode Gp1 der Diodenschaltung Gp antiparallel geschaltet ist, mit dem gemeinsamen Messsignalausgang Sx verbunden. Diese Spannungsteilerschaltung Rp1, Rp2 erzeugt eine Vorspannung, um den Spitzenwertdetektor und die Kapazität Ch der Hochpassfilterschaltung HPF zurückzusetzen.

Optional kann zusätzlich eine aktive Reset-Schaltung Tp für den Spitzenwertdetektor in die Spitzenwertdetektorschaltung PD integriert werden. Die aktive Reset-Schaltung Tp ist zum Beispiel als Transistorschaltung ausgestaltet, wie in Fig. 1 veranschaulicht, und über einen Signaleingang Sr zum Beispiel mit einem Mikrocontroller verbindbar. Mit Hilfe einer solchen aktiven Reset-Schaltung Tp kann die Scangeschwindigkeit der optischen Sensoren erhöht werden.

Mit der Sensorschaltung von Fig. 1 können die jeweils gewünschten Sicherheitsstandards für mehrere berührungs- und/oder annäherungsempfindliche Bedienelemente bei einfachem Aufbau eingehalten werden. Außerdem kann die Sensorschaltung mit einer deutlich reduzierten Anzahl an aktiven Bauelementen (Transistoren, Dioden, etc.) und an passiven Bauelementen (Widerstände, Kapazitäten, etc.) und somit kostengünstiger aufgebaut werden.

Die Verbindung der gemeinsamen Messsignalleitung St mit dem gemeinsamen Messsignalausgang Sx erlaubt mittels einer einfachen Auswertung des am gemeinsamen Messsignalausgang Sx liegenden Signals verschiedene Sicherheitsprüfungen. Insbesondere kann erkannt werden, ob der aktivierte optische Sensor korrekt arbeitet.

Mit der oben beschriebenen Sensorschaltung kann auf einfache Weise eine Vielzahl von Funktionstests durchgeführt werden. Einige dieser Funktionstests werden nachfolgend beispielhaft näher beschrieben.

Ein fehlerhafter Shunt-Widerstand Rx kann erkannt werden, wenn die Spannung am Fehlersignalausgang Ix außerhalb eines vordefinierten Bereichs liegt.

Ein fehlerhafter optischer Sender Dn kann erkannt werden, wenn die Spannung am Fehlersignalausgang Ix außerhalb eines vordefinierten Bereichs liegt.

Ein fehlerhafter optischer Sender Dn kann erkannt werden, wenn die Spannung am Fehlersignalausgang Ix außerhalb eines vordefinierten Bereichs liegt.

Eine kurzgeschlossene Kapazität Cn einer Tiefpassfilterschaltung kann erkannt werden, wenn die Spannung am Fehlersignalausgang Ix außerhalb eines vordefinierten Bereichs liegt. Eine offene Kapazität Cn beeinflusst allenfalls die Empfindlichkeit des optischen Sensors, ist aber nicht sicherheitsrelevant.

Ein offener Widerstand Rn einer Tiefpassfilterschaltung kann erkannt werden, wenn die Spannung in der gemeinsamen Messsignalleitung St außerhalb eines vordefinierten Bereichs, insbesondere nahe Null liegt. Ein kurzgeschlossener Widerstand Rn beeinträchtigt allenfalls die Empfindlichkeit des optischen Sensors, ist aber nicht sicherheitsrelevant.

Ein kurzgeschlossener Widerstand Rs der Signalaufbereitungsschaltung SC kann erkannt werden, wenn die Spannung in der gemeinsamen Messsignalleitung St außerhalb eines vordefinierten Bereichs, insbesondere nahe Null liegt. Ein offener Widerstand Rs kann hingegen erkannt werden, wenn die Spannung in der gemeinsamen Messsignalleitung St außerhalb eines vordefinierten Bereichs, insbesondere nahe einer positiven Versorgungsspannung liegt.

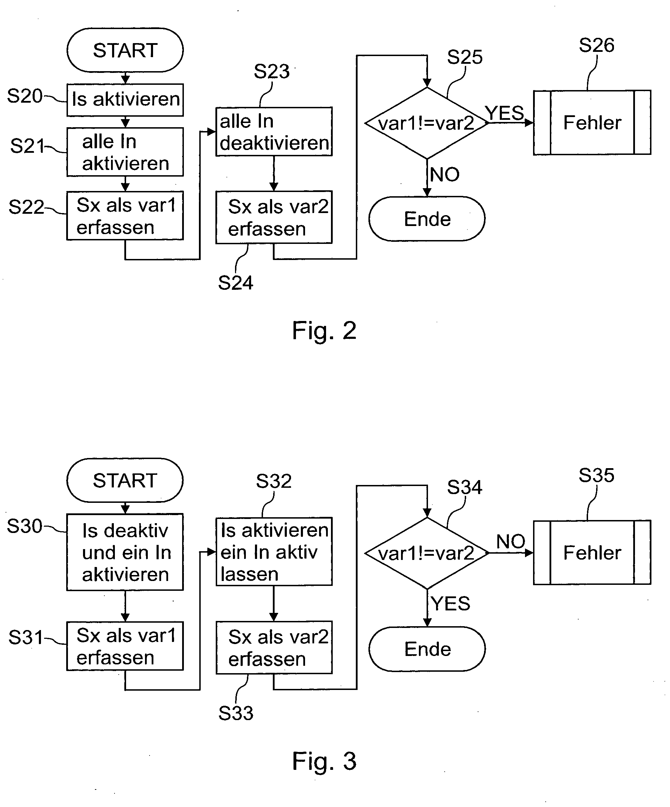

Eine fehlerhafte Kapazität Ch der Hochpassfilterschaltung HPF ist relativ schwierig festzustellen. Fig. 2 und 3 zeigen beispielhaft zwei Test-Routinen zum Erkennen einer kurzgeschlossenen Kapazität Ch bzw. einer offenen Kapazität Ch.

Wie in Fig. 2 veranschaulicht, kann eine kurzgeschlossene Kapazität Ch der Hochpassfilterschaltung HPF erkannt werden, wenn kein Spannungsabfall beim Ausschalten der optischen Sender stattfindet. In einem ersten Schritt S20 wird der gemeinsame Steuersignaleingang Is aktiviert. Dann werden in einem Schritt S21 alle spezifischen Steuersignaleingänge In und damit alle optischen Sender Dn aktiviert. Das Messsignal am gemeinsamen Messsignalausgang Sx wird als Parameter "var1" erfasst und abgespeichert (Schritt S22). Dann werden in einem Schritt S23 alle spezifischen Steuersignaleingänge In deaktiviert, d.h. alle optischen Sender Dn ausgeschaltet. Das entsprechende Messsignal am gemeinsamen Messsignalausgang Sx wird als Parameter "var2" erfasst und abgespeichert (Schritt S24). In Schritt S25 werden die beiden Parameterwerte var1 und var2 miteinander verglichen. Sind die beiden Parameterwerte gleich ("YES"), folgt eine Fehlerroutine (Schritt S26); sind die beiden Parameterwerte hingegen unterschiedlich ("NO"), so wird die Test-Routine von Fig. 2 mit dem Ergebnis abgeschlossen, dass die Kapazität Ch in Ordnung ist.

Wie in Fig. 3 veranschaulicht, kann eine offene Kapazität Ch der Hochpassfilterschaltung HPF erkannt werden, wenn beim Einschalten des PWM-Steuersignals am gemeinsamen Steuersignaleingang Is kein Spannungsabfall eintritt. In einem ersten Schritt S30 wird der gemeinsame Steuersignaleingang Is deaktiviert und wenigstens ein spezifischer Steuersignaleingang In aktiviert. Das Messsignal am gemeinsamen Messsignalausgang Sx wird als Parameter "var1" erfasst und abgespeichert (Schritt S31). Dann wird in einem Schritt S32 der gemeinsame Steuersignaleingang Is aktiviert, während die zuvor aktivierten spezifischen Steuersignaleingänge In aktiviert, d.h. die zugehörigen optischen Sender Dn eingeschaltet bleiben. Das entsprechende Messsignal am gemeinsamen Messsignalausgang Sx wird als Parameter "var2" erfasst und abgespeichert (Schritt S33). In Schritt S34 werden die beiden Parameterwerte var1 und var2 miteinander verglichen. Sind die beiden Parameterwerte gleich ("YES"), folgt eine Fehlerroutine (Schritt S35); sind die beiden Parameterwerte hingegen unterschiedlich ("NO"), so wird die Test-Routine von Fig. 3 mit dem Ergebnis abgeschlossen, dass die Kapazität Ch in Ordnung ist.

Ein offener Widerstand Rh der Hochpassfilterschaltung HPF kann analog zur Test-Routine von Fig. 3 überprüft werden. Bei einem kurzgeschlossenen Widerstand Rh liegt die Spannung am gemeinsamen Messsignalausgang Sx außerhalb eines vordefinierten Bereichs, insbesondere nahe Null.

Fehlerhafte Widerstände Rp1, Rp2 der Spannungsteilerschaltung der Spitzenwertdetektorschaltung PD können durch Messen der Spannung am gemeinsamen Messsignalausgang Sx erkannt werden. Bei einem fehlerhaften Widerstand Rp1, Rp2 liegt diese Spannung außerhalb eines vordefinierten Bereichs, insbesondere nahe der Referenzspannung Vcc oder nahe Masse.

Bei einer fehlenden Diodenschaltung Gp liegt die Spannung am gemeinsamen Messsignalausgang Sx nahe Masse, d.h. außerhalb eines vordefinierten Bereichs. Falls in der Diodenschaltung GP ein Kurzschluss zwischen Anode und Kathode einer Diode Gp1, Gp2 existiert, so ist dies nicht sicherheitsrelevant, da die Schaltung weiter funktioniert und allenfalls die Sensitivität in manchen Fällen sinken kann.

Ein Kurzschluss der Kapazität Cp des Spitzenwertdetektors, des Widerstands Rp3 des Spitzenwertdetektors oder zwischen Kollektor und Emitter der Transistorschaltung Tp können erkannt werden, wenn die Spannung am gemeinsamen Messsignalausgang Sx außerhalb eines vordefinierten Bereichs, insbesondere nahe Null liegt.

Bei einem über den Signaleingang Sr aktivierten Reset sollte die Spannung am gemeinsamen Messsignalausgang Sx nahe Null sein; andernfalls kann eine offene Verbindung zwischen Kollektor und Emitter der Transistorschaltung Tp oder eine Trennung der Basis der Transistorschaltung Tp vom Signaleingang Sr vorliegen.

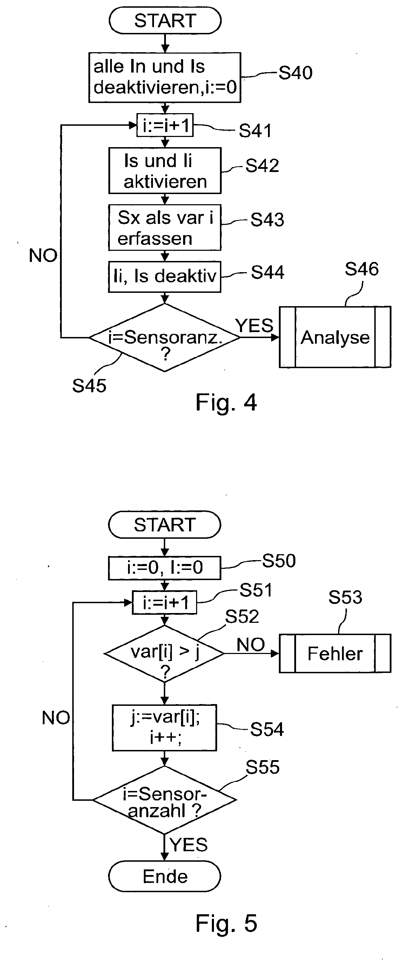

Nachdem die oben beschriebenen Prüfungen bzw. Test-Routinen durchlaufen sind, wird die Funktionsfähigkeit der gemeinsamen Signalaufbereitungsschaltung SC geprüft. Ein möglicher Algorithmus, der beispielhaft in Fig. 4 und 5 veranschaulicht ist, basiert auf einer Veränderung der am gemeinsamen Messsignalausgang Sx gemessenen Spannung.

Zunächst muss jedoch sichergestellt sein, dass optische Sender Dn und optische Empfänger Tn der optischen Sensoren funktionieren, d.h. Licht vom optischen Sender zum optischen Empfänger eines optischen Sensors gelangen kann. Zunächst wird der erste spezifische Steuersignaleingang I1 aktiviert und wird die entsprechende Vorspannung am gemeinsamen Messsignalausgang Sx gemessen. Danach wird das PWM-Signal über den gemeinsamen Steuersignaleingang Is angelegt und wird der sogenannte Dunkelstrom am gemeinsamen Messsignalausgang Sx gemessen. Nach Abschluss der beiden Messungen werden die Messwerte miteinander verglichen. Bei funktionierender Sensorschaltung sollte das Messsignal am gemeinsamen Messsignalausgang Sx ohne PWM-Signal niedriger als mit PWM-Signal sein. Dieser Funktionstest wird für alle optischen Sensoren der Sensorschaltung durchgeführt.

Wenn auf diese Weise sichergestellt ist, dass alle optischen Sensoren der Sensorschaltung funktionieren, kann die Funktionsweise der gemeinsamen Signalaufbereitungsschaltung SC wie folgt geprüft werden.

Zunächst werden in Schritt S40 alle Steuersignaleingänge In und Is deaktiviert. Dann wird in Schritt S42 zunächst der erste optische Sensor (i=1) über die Steuersignaleingänge I1, Is aktiviert und wird dann in Schritt S43 die Spannung am gemeinsamen Messsignalausgang Sx gemessen und als Parameter "var1" abgespeichert. Danach wird der erste optische Sensor in Schritt S44 wieder deaktiviert. Diese Erfassung der Messsignale wird für alle optischen Sensoren wiederholt (Schleife der Schritte S41 bis S45). Anschließend kann in Schritt S46 die Analyse der Messsignale zum Beispiel gemäß der in Fig. 5 gezeigten Routine erfolgen.

Es sei hierbei beispielhaft angenommen, dass die Modulationswiderstände Rnm für die optischen Sensoren so ausgewählt sind, dass sie von Sensor zu Sensor ein fortlaufend größer werdendes Messsignal am gemeinsamen Messsignalausgang Sx erzeugen. Inder Schleife der Schritte S51 bis S55 wird für alle optischen Sensoren geprüft, ob das Messsignal am gemeinsamen Messsignalausgang Sx größer ist als das Messsignal für den vorhergehenden optischen Sensor.

### BEZUGSZIFFERNLISTE

- Ch: Kapazität von HPF
- Cp: Kapazität von PD
- Dn: optischer Sender, insbesondere Photodiode
- Gp: Diodenschaltung von PD
- Gp1: erste Diode von Gp
- Gp2: zweite Diode von Gp
- HPF: Hochpassfilterschaltung
- In: spezifischer Steuersignaleingang eines Sensors
- Is: gemeinsamer Steuersignaleingang der Sensoren
- Ix: Fehlersignalausgang der Sender
- PD: Spitzenwertdetektorschaltung
- Rh: Widerstand von HPF
- Rn, Cn: Tiefpassfilterschaltung
- Rnm: Modulationswiderstand für Empfänger Tn
- Rp1, Rp2: Spannungsteilerschaltung von PD
- Rp3: Widerstand von PD
- Rs: Widerstand von SC
- Rx: Shunt-Widerstand
- SC: gemeinsame Signalaufbereitungsschaltung
- Sr: Signaleingang von SC
- St: gemeinsame Messsignalleitung der Empfänger
- Sx: gemeinsamer Messsignalausgang
- Tn: optischer Empfänger, insbesondere Phototransistor
- Tp: aktive Reset-Schaltung von PD, insbesondere Transistorschaltung
- Vcc: Referenzspannung

## Patentansprüche

1. Sensorschaltung mit mehreren optischen Sensoren, wobei
die mehreren optischen Sensoren jeweils einen optischen Sender (Dn) und einen optischen Empfänger (Tn) aufweisen;
der optische Sender (Dn) und der optische Empfänger (Tn) eines optischen Sensors jeweils mit einem spezifischen Steuersignaleingang (In) verbunden sind;
die optischen Sender (Dn) der mehreren optischen Sensoren mit einem gemeinsamen Steuersignaleingang (Is) verbunden sind;
die optischen Empfänger (Tn) der mehreren optischen Sensoren mit einem gemeinsamen Messsignalausgang (Sx) verbunden sind; und
eine gemeinsame Signalaufbereitungsschaltung (SC) zwischen die optischen Empfänger (Tn) der mehreren optischen Sensoren und den gemeinsamen Messsignalausgang (Sx) geschaltet ist,
**dadurch gekennzeichnet, dass**
den optischen Empfängern (Tn) der mehreren optischen Sensoren jeweils ein Modulationswiderstand (Rnm) parallel geschaltet ist, wobei die Modulationswiderstände (Rnm) der mehreren optischen Sensoren zueinander unterschiedliche Widerstandswerte haben.

2. Sensorschaltung nach Anspruch 1, bei welcher
die gemeinsame Signalaufbereitungsschaltung (SC) eine Spitzenwertdetektorschaltung aufweist.

3. Sensorschaltung nach Anspruch 2, bei welcher
die Spitzenwertdetektorschaltung (PD) eine aktive Reset-Schaltung (Tp) zum Zurücksetzen des Ausgangssignals der Spitzenwertdetektorschaltung aufweist.

4. Sensorschaltung nach einem der vorhergehenden Ansprüche, bei welcher die gemeinsame Signalaufbereitungsschaltung (SC) eine Hochpassfilterschaltung (HPF) aufweist.

5. Sensorschaltung nach einem der vorhergehenden Ansprüche, bei welcher den optischen Empfängern (Tn) der mehreren optischen Sensoren jeweils eine Tiefpassfilterschaltung (Rn, Cn) zugeordnet ist.

6. Sensorschaltung nach einem der vorhergehenden Ansprüche, bei welcher eine Aktivierung der optischen Sender (Dn) der mehreren optischen Sensoren über die spezifischen Steuersignaleingänge (In) und den gemeinsamen Steuersignaleingang (Is) separat voneinander modulierbar ist.

7. Sensorschaltung nach einem der Ansprüche 1 bis 6, bei welcher die spezifischen Steuersignaleingänge (In) der mehreren optischen Sensoren jeweils mit einem ADC-Kanal eines Mikrocontrollers verbunden sind.

8. Sensorschaltung nach einem der Ansprüche 1 bis 6, bei welcher die spezifischen Steuersignaleingänge (In) der mehreren optischen Sensoren jeweils mit einem Ausgang eines Multiplexers oder eines Schieberegisters verbunden sind.

9. Sensorschaltung nach einem der vorhergehenden Ansprüche, bei welcher die optischen Sender (Dn) der mehreren optischen Sensoren mit einem gemeinsamen Fehlersignalausgang (Ix) verbunden sind.

10. Bedienvorrichtung, insbesondere für ein elektronisches Haushaltsgerät, mit mehreren berührungs- und/oder annäherungsempfindlichen Bedienelementen und einer Sensorschaltung nach einem der Ansprüche 1 bis 9.

11. Verfahren zum Betreiben einer Sensorschaltung mit mehreren optischen Sensoren nach einem der Ansprüche 1 bis 9, bei welchem die optischen Sender (Dn) der mehreren optischen Sensoren über die spezifischen Steuersignaleingänge (In) und den gemeinsamen Steuersignaleingang (Is) nacheinander aktiviert werden;
die von den Empfängern (Tn) der mehreren optischen Sensoren erzeugten Messsignale mittels den Empfängern jeweils parallel geschalteten Modulationswiderständen (Rnm), die zueinander unterschiedliche Widerstandswerte haben, moduliert werden; und
die von den Empfängern (Tn) der mehreren optischen Sensoren erzeugten Messsignale von der gemeinsamen Signalaufbereitungsschaltung (SC) aufbereitet und dann ausgewertet werden.

12. Verfahren nach Anspruch 11, bei welchem
vor jeder Aktivierungsschleife der optischen Sender (Dn) der mehreren optischen Sensoren eine Test-Routine der optischen Sensoren ausgeführt wird.

## Claims

1. Sensor circuit having a plurality of optical sensors, wherein
the plurality of optical sensors each have an optical transmitter (Dn) and an optical receiver (Tn);
the optical transmitter (Dn) and the optical receiver (Tn) of an optical sensor are each connected to a specific control signal input (In);
the optical transmitters (Dn) of the plurality of optical sensors are connected to a common control signal input (Is) ;
the optical receivers (Tn) of the plurality of optical sensors are connected to a common measurement signal output (Sx); and
a common signal processing circuit (SC) is connected between the optical receivers (Tn) of the plurality of optical sensors and the common measurement signal output (Sx),
**characterized in that**
a modulation resistor (Rnm) is connected in parallel in each case with the optical receivers (Tn) of the plurality of optical sensors, wherein the modulation resistors (Rnm) of the plurality of optical sensors have different resistances from one another.

2. Sensor circuit according to Claim 1, in which
the common signal processing circuit (SC) has a peak value detector circuit.

3. Sensor circuit according to Claim 2, in which
the peak value detector circuit (PD) has an active reset circuit (Tp) for resetting the output signal of the peak value detector circuit.

4. Sensor circuit according to one of the preceding claims, in which
the common signal processing circuit (SC) has a high-pass filter circuit (HPF).

5. Sensor circuit according to one of the preceding claims, in which
a low-pass filter circuit (Rn, Cn) is assigned in each case to the optical receivers (Tn) of the plurality of optical sensors.

6. Sensor circuit according to one of the preceding claims, in which
activation of the optical transmitters (Dn) of the plurality of optical sensors is able to be modulated separately from one another via the specific control signal inputs (In) and the common control signal input (Is) .

7. Sensor circuit according to one of Claims 1 to 6, in which
the specific control signal inputs (In) of the plurality of optical sensors are each connected to an ADC channel of a microcontroller.

8. Sensor circuit according to one of Claims 1 to 6, in which
the specific control signal inputs (In) of the plurality of optical sensors are each connected to an output of a multiplexer or of a shift register.

9. Sensor circuit according to one of the preceding claims, in which
the optical transmitters (Dn) of the plurality of optical sensors are connected to a common fault signal output (Ix) .

10. Operating device, in particular for an electronic household appliance, having a plurality of touch-sensitive and/or approach-sensitive operating elements and a sensor circuit according to one of Claims 1 to 9.

11. Method for operating a sensor circuit having a plurality of optical sensors according to one of Claims 1 to 9, in which
the optical transmitters (Dn) of the plurality of optical sensors are activated in succession via the specific control signal inputs (In) and the common control signal input (Is);
the measurement signals generated by the receivers (Tn) of the plurality of optical sensors are modulated by way of modulation resistors (Rnm) each connected in parallel with the receivers and having different resistances from one another; and
the measurement signals generated by the receivers (Tn) of the plurality of optical sensors are processed by the common signal processing circuit (SC) and then evaluated.

12. Method according to Claim 11, in which
a test routine is performed on the optical sensors before each activation loop of the optical transmitters (Dn) of the plurality of optical sensors.

## Revendications

1. Circuit de capteur comprenant une pluralité de capteurs optiques,
la pluralité de capteurs optiques comportant chacun un émetteur optique (Dn) et un récepteur optique (Tn) ; l'émetteur optique (Dn) et le récepteur optique (Tn) d'un capteur optique étant chacun reliés à une entrée de signal de commande spécifique (In) ;
les émetteurs optiques (Dn) de la pluralité de capteurs optiques étant reliés à une entrée de signal de commande commune (Is) ;
les récepteurs optiques (Tn) de la pluralité de capteurs optiques étant reliés à une sortie de signal de mesure commune (Sx) ; et
un circuit de traitement de signal commun (SC) étant monté entre les récepteurs optiques (Tn) de la pluralité de capteurs optiques et la sortie du signal de mesure commune (Sx),
**caractérisé en ce que**
une résistance de modulation (Rnm) est montée en parallèle des récepteurs optiques (Tn) de la pluralité de capteurs optiques, les résistances de modulation (Rnm) de la pluralité de capteurs optiques ayant des valeurs de résistance différentes les unes des autres.

2. Circuit de capteur selon la revendication 1, dans lequel
le circuit de traitement de signal commun (SC) comprend un circuit détecteur de crête.

3. Circuit de capteur selon la revendication 2, dans lequel
le circuit détecteur de crête (PD) comporte un circuit de réinitialisation actif (Tp) destiné à réinitialiser le signal de sortie du circuit détecteur de crête.

4. Circuit de capteur selon l'une des revendications précédentes, dans lequel
le circuit de traitement de signal commun (SC) comporte un circuit de filtre passe-haut (HPF).

5. Circuit de capteur selon l'une des revendications précédentes, dans lequel
les récepteurs optiques (Tn) de la pluralité de capteurs optiques sont associés chacun à un circuit de filtre passe-bas (Rn, Cn).

6. Circuit de capteur selon l'une des revendications précédentes, dans lequel
une activation des émetteurs optiques (Dn) de la pluralité de capteurs optiques peut être modulée séparément les uns des autres par le biais des entrées de signal de commande spécifiques (In) et de l'entrée de signal de commande commune (Is).

7. Circuit de capteur selon l'une des revendications 1 à 6, dans lequel
les entrées de signal de commande spécifiques (In) de la pluralité de capteurs optiques sont chacune reliées à un canal ADC d'un microcontrôleur.

8. Circuit de capteur selon l'une des revendications 1 à 6, dans lequel
les entrées de signal de commande spécifiques (In) de la pluralité de capteurs optiques sont chacune reliées à une sortie d'un multiplexeur ou à un registre à décalage.

9. Circuit de capteur selon l'une des revendications précédentes, dans lequel
les émetteurs optiques (Dn) de la pluralité de capteurs optiques sont reliés à une sortie de signal d'erreur commune (Ix).

10. Dispositif de commande, destiné notamment à un appareil domestique, ledit dispositif de commande comprenant une pluralité d'éléments de commande tactiles et/ou sensibles à la proximité et un circuit de capteur selon l'une des revendications 1 à 9.

11. Procédé de fonctionnement d'un circuit de capteur comprenant une pluralité de capteurs optiques selon l'une des revendications 1 à 9, dans lequel
les émetteurs optiques (Dn) de la pluralité de capteurs optiques sont activés successivement par le biais des entrées de signal de commande spécifiques (In) et de l'entrée de signal de commande commune (Is) ;
les signaux de mesure générés par les récepteurs (Tn) de la pluralité de capteurs optiques sont modulés au moyen de résistances de modulation (Rnm) montées chacune en parallèle des récepteurs et ayant des valeurs de résistance différentes les unes des autres ; et
les signaux de mesure générés par les récepteurs (Tn) de la pluralité de capteurs optiques sont traités par le circuit de traitement de signal commun (SC) puis évalués.

12. Procédé selon la revendication 11, dans lequel
une routine de test des capteurs optiques est exécutée avant chaque boucle d'activation des émetteurs optiques (Dn) de la pluralité de capteurs optiques.
